# EUROPÄISCHE PATENTSCHRIFT

(11) **EP 2 265 744 B1**
(45) Veröffentlichungstag und Bekanntmachung des Hinweises auf die Patenterteilung: **07.05.2014**
(21) Anmeldenummer: 09734873.4
(22) Anmeldetag: 06.02.2009
(51) Int. Cl.: C23C 14/32, C23C 14/34, C23C 14/08

(54) **VERFAHREN ZUM HERSTELLEN VON METALLOXIDSCHICHTEN VORBESTIMMTER STRUKTUR DURCH FUNKENVERDAMPFUNG**
METHOD FOR PRODUCING METAL OXIDE LAYERS HAVING A PRE-DEFINED STRUCTURE BY WAY OF ARC EVAPORATION
PROCÉDÉ DE PRODUCTION DE COUCHES D'OXYDES MÉTALLIQUES D'UNE STRUCTURE DÉFINIE PAR ÉVAPORATION PAR ARC

(30) Priorität: 24.04.2008 US 47591; 19.09.2008 EP 08016572
(43) Veröffentlichungstag der Anmeldung: 29.12.2010
(73) Patentinhaber: Oerlikon Trading AG, Trübbach, 9477 Trübbach (CH)
(72) Erfinder: RAMM, Jürgen, CH-7304 Maienfeld (CH)
(74) Vertreter: Naefe, Jan Robert
(86) Internationale Anmeldenummer: PCT/EP2009/000852
(87) Internationale Veröffentlichungsnummer: WO 2009/129880

(56) Entgegenhaltungen:
- EP-A- 1 348 776
- EP-A- 1 391 533
- WO-A-2008/009619
- DE-A1- 19 522 331
- STAHR C C ET AL: "Dependence of the stabilization of [alpha]-Alumina on the spray process" JOURNAL OF THERMAL SPRAY TECHNOLOGY DECEMBER 2007 SPRINGER NEW YORK LLC US, Bd. 16, Nr. 5-6, Dezember 2007 (2007-12), Seiten 822-830, XP002530250

## Beschreibung

Die Erfindung betrifft ein Verfahren zum Herstellen von Metalloxidschichten durch Funkenverdampfung nach dem Oberbegriff des Anspruchs 1.

Insbesondere betrifft die Erfindung die Herstellung, Auswahl und den Betrieb sogenannter "Legierungstargets", d.h. Targets, die aus mindestens zwei metallischen und/oder halbmetallischen Komponenten bestehen und die als Verdampfungsquellen bei der kathodischen Funkenverdampfung dienen.

Von besonderer Bedeutung ist die Erfindung für "Legierungstargets", die aus Metallen mit sehr unterschiedlichen Schmelztemperaturen zusammengesetzt sind.

Diese Legierungstargets werden definiert als mindestens zwei metallische Komponenten umfassend, die aber auch als intermetallische Verbindungen und/oder Mischkristalle vorliegen können.

Ein pulvermetallurgisches Target ist hierbei ein Target, das aus Pulver von Metallen, Halbmetallen, intermetallischen Verbindungen, Mischkristallen hergestellt wird und bei dem man nach dem Herstellungsprozess (beispielsweise einem heißisostatischen Press-Prozess) noch die Körner des Pulvers im Mikroskop auflösen kann. Ein pulvermetallurgisches Legierungstarget kann somit aus einer Mischung aus Pulvern von Metallen und/oder Halbmetallen, einem Pulver aus einer intermetallischen Verbindung oder einer Mischung aus Pulvern von Metallen und/oder Halbmetallen und oder intermetallischen Verbindungen hergestellt sein. Im Gegensatz hierzu ist ein schmelzmetallurgisches Legierungstarget ein Target, bei dem die Ausgangsmetalle bzw. Halbmetalle eine intermetallische Phase bilden. Charakteristisch hierfür ist, dass im Mikroskop die Körner des Ausgangsmaterials nicht mehr aufgelöst werden können, d.h. nicht mehr vorliegen.

Zudem gibt es sogenannte plasmagespritzte Targets. Dies sind Targets, die durch Plasmaspritzen hergestellt worden sind. Bei diesen Targets kann es zu einer teilweisen oder vollständigen Bildung von intermetallischen Komponenten der Ausgangsmaterialien kommen. Allgemein kann aber das plasmagespritzte Target sowohl Körner als auch intermetallische Phasen enthalten.

Die kathodische Funkenverdampfung ist ein seit Jahren etabliertes Verfahren, das zur Beschichtung von Werkzeugen und Bauteilen Anwendung findet und mit dem sowohl metallische Schichten in breiter Vielfalt als auch Metallnitride und Metallcarbonitride abgeschieden werden. Bei all diesen Anwendungen sind die Targets Kathode einer Funkenentladung, die bei niedrigen Spannungen und hohen Strömen betrieben wird und mit der das Target(Kathoden)material verdampft wird. Als einfachste und billigste Stromversorgungen zum Betreiben der Funkenentladungen werden Gleichspannungsstromversorgungen benutzt.

Problematischer ist die Herstellung von Metalloxiden mittels Funkenverdampfung. Es ist schwierig, eine Gleichstromfunkenentladung in Sauerstoff bzw. sauerstoffhaltiger Atmosphäre zu betreiben, um oxidische Schichten etwa auf Werkzeugen oder Bauteilen abzuscheiden. Es besteht dann die Gefahr, dass sich die beiden Elektroden der Gleichstromentladungen (einerseits das Target als Kathode sowie andrerseits die Anode, die oft auf Massepotential betrieben wird) mit isolierenden Schichten belegen. Das führt auf dem Target (Kathode) dazu, dass sich je nach Quellendesign (Magnetfeld, Ort und Art des Gaseinlasses) der elektrisch leitende Bereich, in dem der Funken läuft, einschnürt und es schließlich zu einem Unterbruch der Funkenentladung kommt.

In T.D. Schemmel, R.L. Cunningham, and H. Randhawa, Thin Solid Films 181 (1989) 597, wird ein Hochratebeschichtungsprozess für Al₂O₃ beschrieben. Der Sauerstoffgaseinlass wurde nach der Filterung des Funkens in der Substratnähe eingelassen. Es wird erwähnt, dass der Einlass des Sauerstoffs nach dem Filter in der Nähe des Substrates wichtig ist, um die Oxidation des Targets zu reduzieren und die Funkenentladung zu stabilisieren.

In der US 5 518 597 wird ebenfalls die Herstellung oxidischer Schichten beschrieben. Die Schrift beinhaltet die Schichtabscheidung bei erhöhten Temperaturen und beruht darauf, dass auch die Anode geheizt (800°C - 1200°C) und das Reaktivgas nicht direkt beim Target eingelassen wird. Die hohe Anodentemperatur hält die Anode leitend und ermöglicht einen stabilen Betrieb der Funkenentladung.

In US 2007/0000772 A1, WO 2006/099760 A2 und WO 2008/009619 A1 wird ausführlich das Betreiben einer Funkenentladung in Sauerstoffatmosphäre beschrieben und auf die Methoden eingegangen, unter denen ein vollständiges Belegen mit einer für Gleichstrom (DC) undurchlässigen Isolationsschicht auf der Kathode vermieden werden kann.

US 2007/0000772 A1 und WO 2006/099760 A2 beschreiben vor allem das Betreiben der Funkenquelle mit gepulstem Strom als einen wesentlichen Faktor, die Kathodenfläche frei von undurchlässigen Oxidschichten zu halten und eine stabile Funkenentladung zu gewährleisten. Durch das Pulsen des Funkenstroms, zu dem spezielle Stromversorgungen notwendig sind, wird der Funken ständig auf neue Bahnen über das Target gelenkt und verhindert, dass er sich lediglich in bevorzugten Bereichen bewegt und die übrigen Targetbereiche sich mit dickem Oxid belegen (wie das beim "steered arc" (geführter Funke) der Fall ist).

In WO 2008/009619 A1 wird das Betreiben der Funkenentladung in Sauerstoffatmosphäre beschrieben, wobei die Kathode mit einem bevorzugt kleinen und zur Targetoberfläche senkrecht stehenden Magnetfeld versehen ist. Dieses ermöglicht einen über die Targetoberfläche regelmäßigen Funkenverlauf und verhindert damit ebenfalls eine für den Gleichstrom undurchlässig dicke Aufoxidation des Targets.

Auf der Basis dieser drei Schriften des Standes der Technik ist es möglich, eine stabile Funkenentladung über mehrere Stunden in reiner Sauerstoffatmosphäre zu gewährleisten. Diese Verfahren arbeiten stabil und reproduzierbar für elementare Targets und für schmelzmetallurgisch hergestellte Targets.

Charakteristisch für die mittels Funkenverdampfen hergestellten Schichten sind nicht vollständig durchoxidierte Droplets aus Metall, welche schwer zu vermeidende metallische Konglomerate in der Schicht bilden. Im Falle von Legierungstargets bilden sich diese Droplets vorrangig aus dem höherschmelzenden Metall oder einer im Wesentlichen der Zusammensetzung des Targets entsprechenden Legierungen. Es gibt technisch aufwendige Massnahmen, solche Droplets zu vermeiden, beispielsweise über eine Filterung. D.h. nicht alle durch Funkenverdampfen hergestellte Schichten weissen Droplets auf. Alle Schichten die die Droplets aufweisen, wurden aber durch Funkenverdampfen hergestellt.

Die zunehmende Nutzung der Funkenverdampfung zur Herstellung unterschiedlichster Metalloxide erfordert eine flexible und kostengünstige Targetproduktion. Viele Targets werden in einem dem Fachmann bestens bekannten Verfahren mittels heißisostatischem Pressen (HIP) hergestellt. Falls man beispielsweise ein Al-Cr-Target fertigen möchte, wird ein Pulver oder Pulvergemisch gewünschter Zusammensetzung aus den Elementen (hier beispielhaft und ohne Einschränkung: Al und Cr) in einem Behälter eingeschlossen, der in Vakuum hohen Temperaturen ausgesetzt wird, um Luft und Feuchtigkeit im Pulver zu reduzieren. Der Container wird anschließend verschlossen und bei hoher Temperatur hohem Druck ausgesetzt. Dieses Verfahren reduziert die inneren Hohlräume und schafft eine gewisse Bindung des Pulvers. Das resultierende Material besitzt eine uniforme Verteilung bezüglich der Korngröße und annähernd 100 % Dichte.

Aus der DE 195 22 331 A1 ist ein Verfahren zum Beschichten eines Werkstückes mittels kathodischen Bogenverdampfens sowie eine Anlage zur Durchführung dieses Verfahrens bekannt. Das hierbei verwendete Target weist eine Metalllegierung in einer einzigen kristallographischen Phase auf. Bevorzugt ist dabei eine Legierung aus Aluminium und Chrom. Die Verwendung eines Targets mit nur einer kristallographischen Phase führt laut dieser Druckschrift zu einem wesentlich besseren Kathodenpunktverhalten.

Aufgabe der Erfindung ist es, ein Verfahren zum Herstellen von Metalloxidschichten durch Funkenverdampfen zu schaffen, mit welchem Metalloxidschichten einer vorbestimmten Kristallstruk-tur zuverlässig abgeschieden werden können.

Die Aufgabe wird mit einem Verfahren mit den Merkmalen des Anspruch 1 gelöst.

Vorteilhafte Weiterbildungen sind in den hiervon abhängigen Unteransprüchen gekennzeichnet.

Es wurde beobachtet, dass die am Substrat mittels Funkenverdampfung synthetisierte Metalloxidschichten bei der Verwendung von Legierungstargets betreffs der metallischen Anteile im Wesentlichen eine Zusammensetzung aufweisen, die, was nicht erstaunlich ist, der Zusammensetzung der Legierungstargets entspricht. Erstaunlicherweise lässt sich aber auch die Kristallstruktur der abgeschiedenen Schichten durch die Zusammensetzung der Legierungstargets stark und kontrolliert beeinflussen. Das war besonders überraschend für pulvermetallurgische Targets, da bei diesem ja noch getrennte Körner der Legierungsmaterialien im Target vorliegen. Es konnte weiterhin eine Beeinflussung der Kristallstruktur und/oder der Phasenzusammensetzung der synthetisierten Metalloxidschicht am Substrat beobachtet werden in Abhängigkeit der Targetlegierungszusammensetzung. Eine Erklärung hierfür wäre, dass eine Synthese der die Metalloxidschichten bildenden Materialien mittels Funkenverdampfung bereits zu einem wesentlichen Teil an der Targetoberfläche stattfindet, was durchaus im Gegensatz zu den üblichen Vorstellungen über die Herstellung von PVD Schichten ist, die eher von der Synthese der Materialien am Substrat ausgehen.

Erfindungsgemäß kann man unter Benutzung der Phasendiagramme, die Bildungstemperatur für das Oxid, das bei der Funkenverdampfung synthetisiert wird, über die Zusammensetzung des Funkentargets festlegen, wobei es prinzipiell unwichtig ist, ob das Target als pulvermetallurgisches Target (mit kleiner Korngröße kleiner 300 µm) vorliegt oder auf eine andere Art (schmelzmetallurgisch, durch Schmieden oder durch Plasmaspritzen) hergestellt wurde.

Phasendiagramme werden in der Regel dadurch gewonnen, dass ausgehend von einer hohen Temperatur ein Flüssigkeitsgemisch abgekühlt wird und die Entstehung der unterschiedlichen Phasen und der Phasenübergänge gemessen werden.

Demgegenüber ist der Prozess des Funkenverdampfens ein Prozess, der festes Material in die Dampfphase überführt, wobei typische Funkenlebensdauern unter einer µs liegen und der Durchmesser eines Funkenkraters im µm-Bereich oder sogar nur im nm-Bereich liegt. Die Funkenverdampfung ist also ein sehr kurzer Prozess und der Funken findet auf einer Fläche Platz, die klein ist im Vergleich zu den Korngrössen in einem pulvermetallurgisch hergestellten Target. Daher ist die Absicht, zur Bildung von Metalloxidschichten mittels Funkenverdampfung Phasendiagramme als Hilfsmittel heranzuziehen eher abwegig. Gemäss vorliegender Erfindung hat sich aber gezeigt, dass sich die Bildungstemperatur der Oxide beim Funkenverdampfen anhand des im Phasendiagramm abzulesenden Übergangs aus der vollständig flüssigen Phase in eine feste Bestandteile umfassende Phase ermitteln lässt. Basierend auf diesem Rezept lässt sich nun eine gezielte Auswahl der Bildungstemperatur von Oxiden treffen. Da die Bildungstemperatur der Oxide beispielsweise maßgeblichen Einfluss auf die Kristallstruktur der mit diesen Oxiden aufzubauenden Schichten hat, ist hierdurch eine gezielte Synthese gewünschter Kristallstrukturen mittels Funkenverdampfen möglich. Warum dieser Übergang aus der Flüssigphase diese Bildungstemperatur festlegt, konnte der Erfinder bisher nicht klären.

In den Erläuterungen wird sich auf Legierungstargets bestehend aus zwei metallischen oder halbmetallischen Komponenten bezogen, obwohl alles Gesagte sinngemäß auch für Targets mit mehr als zwei Komponenten ("höhere Legierungen") gilt, unabhängig vom Herstellungsweg.

Die Erfindung wird beispielhaft anhand einer Zeichnung erläutert, es zeigen dabei:
- Figur 1:: das binäre Phasendiagramm von Al-Cr;
- Figur 2:: das ternäre Phasendiagramm von Al-Cr-O;
- Figur 3:: das binäre Phasendiagramm von Al-Nb;
- Figur 4:: Teil eines ternären Phasendiagramms von Al-Nb-O;
- Figur 5:: Teil eines modifizierten ternären Phasendiagramms von AL-Nb-O nach Misra

- Figur 6:: das Ergebnis einer Analyse mittels Elektronenbeugung an einer Al-Nb-O-Schicht;

Erfindungsgemäss lässt sich nun die Struktur des abzuscheidenden Oxids auf der Basis der Phasendiagramme der metallischen oder halbmetallischen Komponenten, aus denen das Oxid synthetisiert wird, ablesen. Das heisst, dass beispielsweise für ein ternäres Al-Cr-O das binäre Phasendiagramm von Al-Cr zu Rate gezogen wird. Für ein quarternäres Oxid wird dann entsprechend das ternäre Phasendiagramm der oxidbildenden Metalle oder Halbmetalle konsultiert. Das Target für die Funkenverdampfung wird nun aus den Metallen oder Halbmetallen ausgebildet, aus denen das Oxid entsprechender Struktur gebildet werden soll. Die Targetzusammensetzung wird so gewählt, dass die Temperatur in den Übergang zur Flüssigphase entsprechend Phasendiagramm die Bedingungen für die Bildungstemperatur des Oxids der gewünschten Struktur erfüllt. Zur Oxidbildung kommt es dann durch die Reaktion des verdampften oder zu verdampfenden Targetmaterials mit dem Sauerstoff.

Dies bedeutet, dass gegebenenfalls zur Erzeugung einer bestimmten gewünschten Struktur Legierungstargets gezielt erzeugt werden, welche laut Phasendiagramm die Abscheidung des Hauptelements des Legierungstargets als Oxid in der entsprechenden Struktur, beispielsweise bei Al als Hauptelement in das Al₂O₃ in Korundstruktur, versprechen.

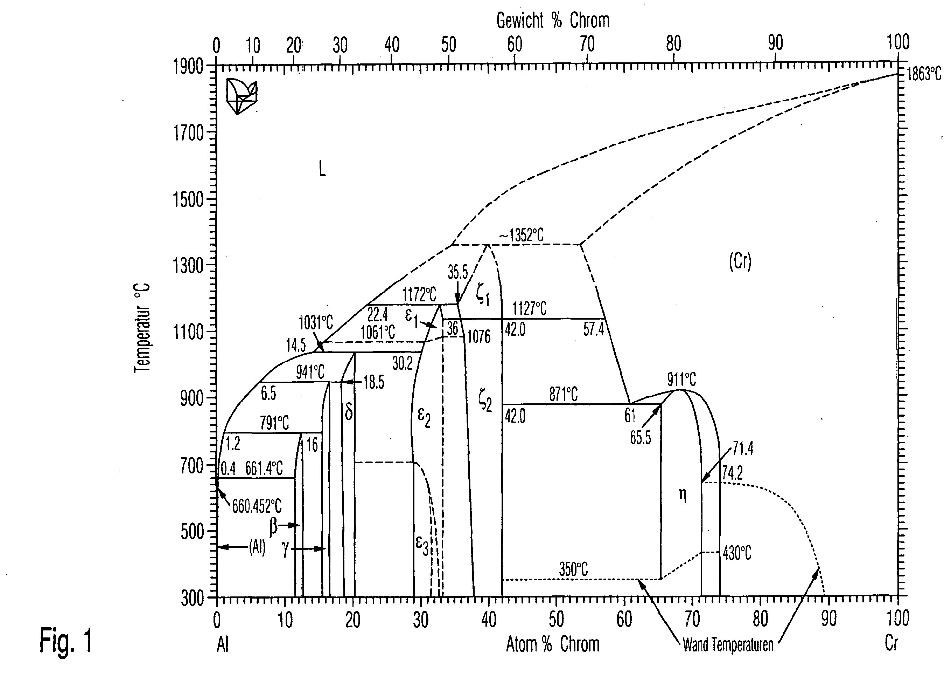

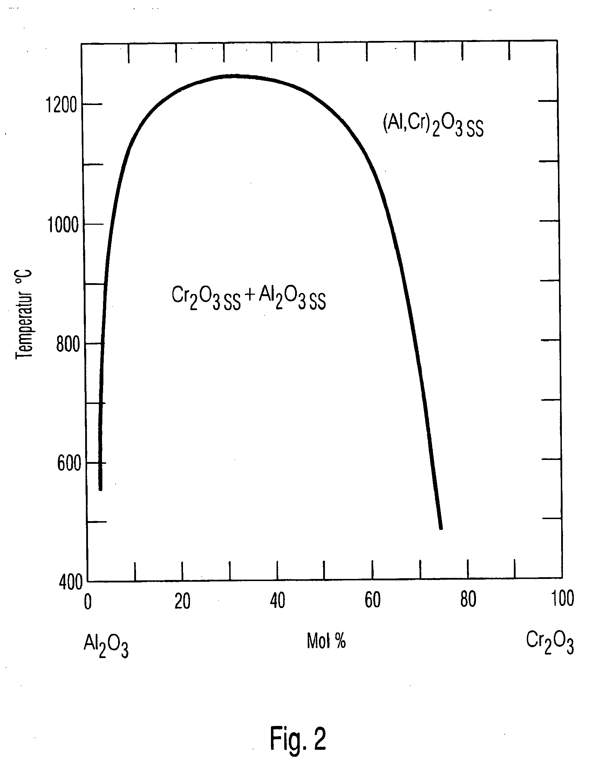

Es hängt von den beteiligten metallischen oder halbmetallischen Komponenten, aus denen das Legierungstarget besteht, ab, zu welchem Resultat die Synthese des Oxids führt. Im Falle eines Al-Cr-Targets kommt es über große Konzentrationsbereiche zur Mischkristallbildung, wie es aus dem Vergleich des binären Phasendiagramms des Al-Cr Materialsystems (siehe Figur 1) mit dem Phasendiagramm des ternären Al-Cr-O, wie in Figur 2 dargestellt, hervorgeht und hier näher erläutert werden soll.

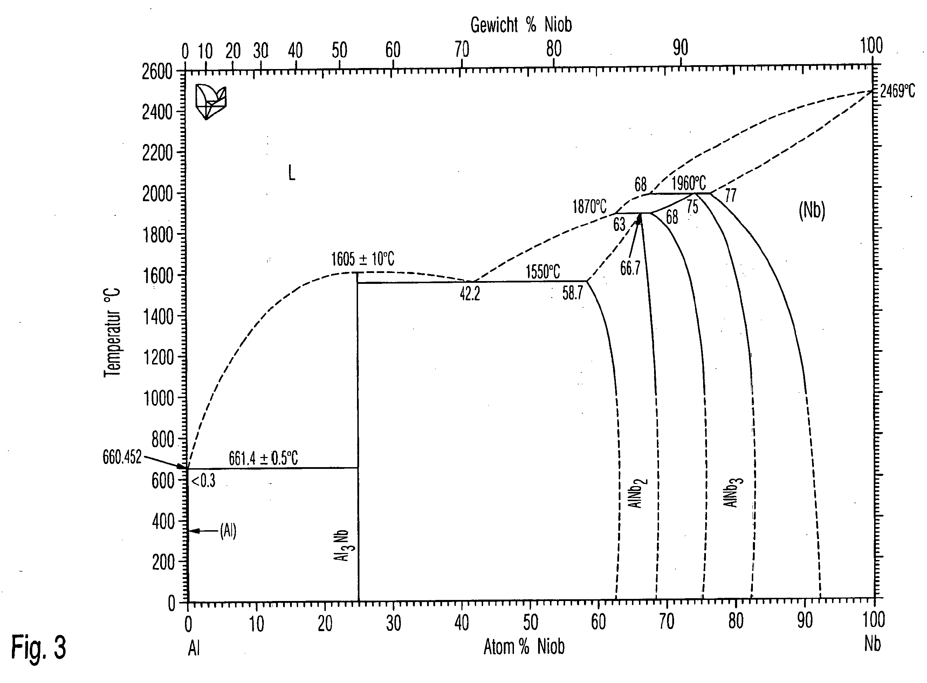

Der Vergleich zwischen Figur 2 und Figur3 zeigt, dass für Targets mit weniger als 75 at% Al die Temperatur für den Übergang in die Flüssigphase (Figur 1) immer über der Temperatur für die Mischkristallbildung bei der entsprechenden Targetzusammensetzung liegt. Daraus schloss der Erfinder, dass für Targets mit weniger als 75 at% Al die Bildungstemperatur (Übergang in die Flüssigphase) für das Oxid immer über der Temperatur liegt, die notwendig ist, um Al-Cr-O Mischkristalle (Bereich oberhalb der Kurve in Figur 2)zu erzeugen.

Für 90 at% Al ist das aber beispielsweise nicht mehr der Fall. Für diese Konzentration findet der Übergang in die Flüssigphase bei weniger als 1000°C statt, wie das binäre Phasendiagramm (Figur 1) zeigt. Aus Figur 2 geht aber hervor, dass bei diesem Legierungsverhältnis nur oberhalb 1100°C ein Mischkristall vorliegt. Demnach wird bei einer Funkenverdampfung von einem Legierungstarget, das aus 90 at% Al und 10 at% Cr besteht, eine Schicht synthetisiert, die keinen Mischkristall bildet, sondern aus getrennten Phasen des Al-O und Cr-O besteht. Aber auch für diese getrennten Phasen legt die Temperatur beim Übergang in die Flüssigphase (Figur 1) die Kristallstruktur fest, wie der Erfinder überraschenderweise herausgefunden hat. Da für ein Bildung von Aluminiumoxid in Korundphase aber mehr als 1000°C benötigt werden, findet man demnach mit einer solchen Targetzusammensetzung auch keine Korundphasenbildung des Aluminiumoxids.

Bei weniger als 90 at% Al liegt jedoch gemäss Figur 1 ein Übergang in die Flüssigphase erst oberhalb 1000° vor. Sofern der Anteil Al im Target jedoch oberhalb 75 at% gehalten wird, kann es nicht zur Mischkristallbildung kommen, wie oben beschrieben. Somit ist es möglich Aluminiumoxid in Korundstruktur ohne parasitäre Mischkristallbildung herzustellen, indem Legierungstargets zur Funkenverdampfung verwendet werden, die einen Aluminiumgehalt zwischen 75 at% und weniger als 90 at% Al aufweisen.

Im Unterschied zur US20080090099 in der die Herstellung von Mischkristallen mit Al2O3 in Korundstruktur auf der Basis von Legierungstargets mit Al/Cr Zusammensetzung von 30/70 oder noch weniger Aluminiumgehalt diskutiert wird, werden im vorliegenden Beispiel also gerade die Bildung von Mischkristallen effizient vermieden.

In Tabelle 1 der US2008090099 wird ein Legierungstarget Al/Cr mit Zusammensetzung 90/10 aufgeführt und die entsprechenden Gitterkonstanten der Korundstruktur angegeben. Dabei ist zu beachten, dass es sich dort nicht um experimentelle Werte handelt sondern um interpolierte Werte. Wie oben ausführlich diskutiert, führt diese Konzentration gerade nicht zu Al2O3 in Korundstruktur oder zu einer Bildung des Mischkristalls. US20080090099 führt daher geradezu in die falsche Richtung, d.h. weg von der vorliegenden Erfindung.

Konkret kann man beispielsweise gemäss vorliegender Erfindung zu 80 at% Al Legierungsanteil im Target gehen. In diesem Legierungsverhältnis findet der Übergang in die flüssige Phase bei etwa 1100°C statt. Um aber ein Mischkristalloxid zu erzeugen, sind bei diesem Legierungsanteil Temperaturen von nicht weniger als 1200°C notwendig (siehe Figur 2). Das hat zur Folge, dass die Oxide der Legierungen nicht als Mischkristall, sondern getrennt synthetisiert werden, dass aber das dabei entstehende Aluminiumoxid bei 1100°C gebildet wird und dementsprechend in der thermodynamisch stabilen Korundphase vorliegt.

Dies steht im Gegensatz zu dem, was in Anspruch 6 der US2008090099 behauptet wird, welcher eine Mischkristallbildung bei u.a. 80% Aluminiumgehalt proklamiert

Der Nachweis der Kristallstruktur kann, wie dem Fachmann bekannt, mittels Röntgenbeugung erfolgen. In manchen Fällen, vor allem bei den oft erwünschten niedrigen Substrattemperaturen, sind die Kristallitgrössen aber zu klein für eine Röntgenbeugung. Im vorliegenden Fall wurde deshalb eine Analyse mittels Elektronenbeugung durchgeführt und mittels derer an den Kristalliten von etwa 10nm Größe zweifelsfrei die Korundstruktur nachgewiesen wurde.

Es soll noch ein anderes Beispiel angeführt werden, in welchem es jedoch bezüglich der metallischen oder halbmetallischen Komponenten zu keinem frei mischbaren Oxid (Mischkristallbildung) bei der Schichtsynthese kommt, wie es im Al-Cr-O System der Fall ist, und bei dem sich vor allem Phasengemische der Oxide bilden. Dazu wurde das Al-Nb-Materialssystem gewählt, dessen binäres Phasendiagramm in Figur 3 dargestellt ist. Auch hier zeigte sich, dass die Zusammensetzung des Targets bezüglich dessen metallischer und halbmetallischer Komponente die Übergangstemperatur aus der Flüssigphase heraus festlegt und damit, nach der Idee des Erfinders, die Bildungstemperatur des Metalloxids definiert.

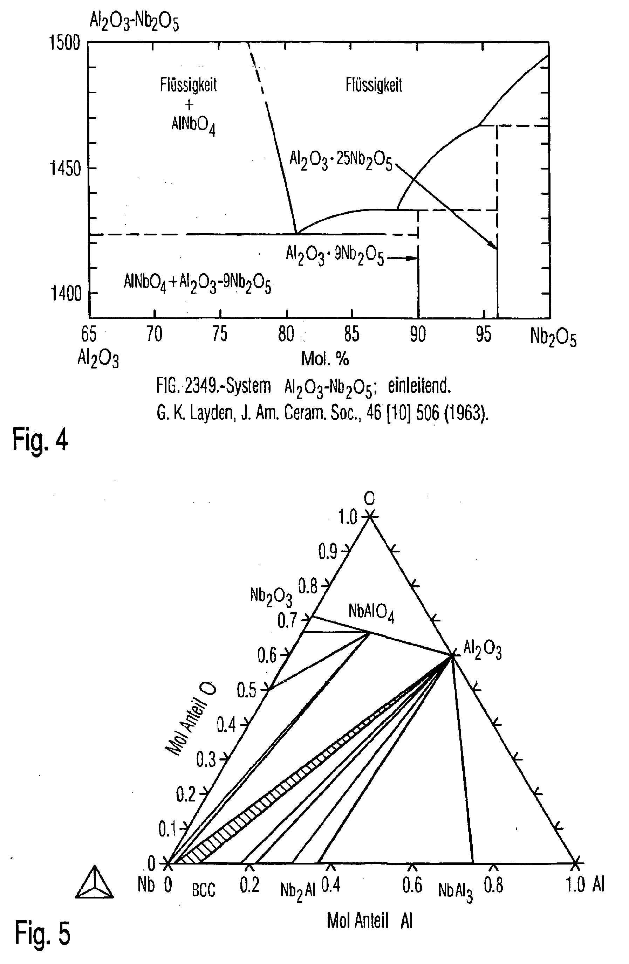

Erfindungsgemäss und dem Rezept folgend, hängt es wieder von den beteiligten metallischen oder halbmetallischen Komponenten ab, aus denen das Legierungstarget besteht, zu welchem Resultat die Synthese des Oxids führt. Im Falle des Al-Targets, dem 10 at% Nb beigemischt sind, verändert sich die Bildungstemperatur des synthetisierten Metalloxides am Substrat von ca. 680°C (elementares Al-Target) auf ca. 1300°C (Legierung mit 10 at% Nb, Figur 3). Für diese Temperatur liefert das Phasendiagramm des ternären Al-Nb-O von Misra (Figur 5) ein Phasengemisch, das neben Nb2O5 und NbAlO4 auch Al2O3 umfasst. Da dieses Al2O3 erfindungsgemäss bei 1300°C gebildet wurde, liegt es in Korundstruktur vor, was durch Elektronenbeugung nachgewiesen werden kann.

Während für die binären Systeme die Phasendiagramme meist gut untersucht sind, kann es vorkommen, dass die Phasendiagramme der entsprechenden ternären Oxide nicht für alle Temperaturbereiche untersucht wurden und diese deshalb nicht wie im Falle des Al-Cr-O Materialsystems vorliegen. Auch sind die Phasendiagramme der ternären Oxide meist komplizierter als es das Phasendiagramm für Al-Cr-O ist, das im Wesentlichen einen bereich von Mischkristallbildung und getrennter binärer Oxidphasen beinhaltet. Dann lassen sich aber Phasendiagramme aus benachbarten Temperaturbereichen für eine Abschätzung heranziehen.

Im Falle des Al-Nb-O konnte beispielsweise der Erfinder mit einer Targetzusammensetzung von 80 at% Al und 20 at% Nb aus dem binaren Phasendiagramm wie in Figur 3 dargestellt eine Oxidbildungstemperatur von etwa 1600°C abschätzen, jedoch kein Phasendiagramm des ternären Systems bei dieser Temperatur ausfindig machen.

Figur 4 (Layden) stellt nur den Temperaturbereich bis 1500°C für das ternäre System dar. Auch das modifizierte Phasendiagramm von Misra für das ternäre System aus dem Jahr 2005 (Figur 5) für das gleiche Materialsystem wurde lediglich für 1300°C gemessen:

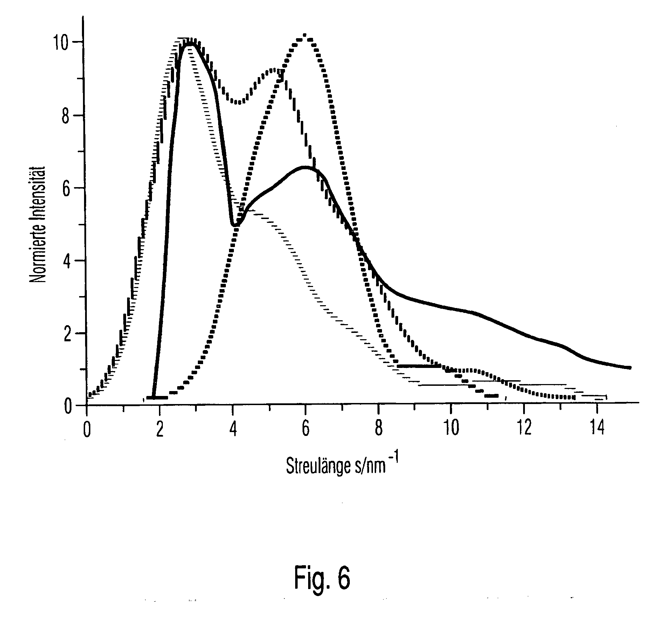

Die Erhöhung des Nb-Gehaltes im Legierungstarget führt, wie bereits erwähnt, nach Figur 3 zu einer Erhöhung der Metalloxidbildungstemperatur auf ca. 1600°C. Auf der Basis der beiden vorliegenden Diagramme für das ternäre System (Figuren 4 und 5) kann man aber vermuten, dass es bei 1600°C wohl vor allem zu einer Bildung von AlNbO4 kommen müsste mit eventuellen Anteilen von Nb2O5 und mit mindestens 60 mol% Aluminiumoxid. Da die Oxidbildungstemperatur bei etwa 1600°C liegt, weist im Wesentlichen sämtliches Aluminiumoxid die Hochtemperaturphase auf, liegt also in Korundstruktur vor. Wieder wurde Elektronenbeugung an den so synthetisierten Schichten vorgenommen. In Figur 6 ist die gemessene Intensitätsverteilung des Elektronenbeugungsdiagramms mit der durchgezogenen fetten Linie dargestellt. Die Lage der Intensitätspeaks für AlNbO4 (vertikal gestrichelte, fette Linie mit zwei ausgeprägten Peaks), Nb2O5 (horizontal gestrichelte Linie mit lediglich einem Maximum welches bei ca 2.4nm Streulänge liegt) und A1203 in Korundstruktur (gestrichelte Linie mit Maximum bei einer Streulänge von ca. 6nm) sind demgegenüber simulierte Kurven. Es wurde davon abgesehen, auch die Intensitäten rechnerisch zu simulieren, da diese mit zu vielen Annahmen verbunden wäre. Die Lage der Intensitätspeaks zeigen aber deutlich, dass die synthetisierte Schicht im Wesentlichen aus einem Gemisch von AlNbO4 und Aluminiumoxid in Korundstruktur besteht, was man daran erkennt, dass die Lage der zwei lokalen Intensitätsmaxima in der gemessenen Kurve bei jenen Streulängen auftreten, für die auch die Intensitätsmaxima der simulierten (berechneten) Kurven für AlNbO4 und Al2O3 (Korund) liegen. Demgegenüber sind die Intensitätsmaxima des berechneten Nb2O5 bezüglich der Streulänge etwas verschoben, wobei aber natürlich nicht ausgeschlossen werden kann, das auch Anteile von Nb205 in der synthetisierten Schicht enthalten sind.

Die Möglichkeit, die Bildungstemperatur des Oxides bei der Schichtsynthese festzulegen und die Ergebnisse der Elektronenbeugung führten also zu der überraschenden Möglichkeit, auf dem oben dargestellten Rezept ein Verfahren aufzubauen, mit dem sich Hochtemperaturoxide von niederschmelzenden Materialien herstellen lassen. Mit anderen Worten: man kann mit diesem Verfahren den Schmelzpunkt eines niederschmelzenden Materials soweit erhöhen, dass die notwendigen Temperaturen zur Bildung einer bestimmten Oxidphase erreicht werden, die ansonsten bei einer Funkenverdampfung nicht erreicht werden können, weil der Schmelzpunkt des niederschmelzenden Metalls weit unter der Bildungstemperatur des Hochtemperaturoxides liegt.

Obwohl das ganze allgemein gilt, soll hier besonders und ohne Einschränkung nochmals auf das wichtige Beispiel der Herstellung von Aluminiumoxid in Korundstruktur eingegangen werden, das nicht ohne weiteres durch Funkenverdampfung eines elementaren Aluminiumtargets möglich ist, da der Schmelzpunkt von Aluminium mit 660°C weit unter der Bildungstemperatur von Korund (ca. 1000°C) liegt. Basierend auf den bisherigen Erläuterungen geht man dabei folgendermaßen vor.

Um die Bildungstemperatur des Aluminiumoxids auf etwa 1000°C heraufzusetzen, sucht man sich ein geeignetes höherschmelzendes Material und stellt mit diesem ein Legierungstarget her (ohne Einschränkung im Herstellungsverfahren), wobei der prozentuale Gehalt der höherschmelzenden Materialkomponente so abgestimmt ist, dass nach dem binären Phasendiagramm mindestens eine Oxidbildungstemperatur von 1000°C erreicht wird. Dabei können schon sehr geringe Beimengungen zum Target zu einer solchen Erhöhung der Oxidbildungstemperatur führen. Im Falle von Nb (Figur 3) genügen schon etwa 3 at%. Wieder wurden die auf diese Art hergestellten Schichten mittels Elektronenbeugung untersucht und es konnte die Korundphase des Aluminiumoxids nachgewiesen werden.

Die Erfindung erlaubt noch eine weitere wesentliche Beeinflussung der zu synthetisierenden Schicht. Dies ist die Beeinflussung der Kristallitgrösse von 10nm bis 500nm über die Bildungstemperatur des Metalloxides. PVD Prozesses sind u.a. dadurch gekennzeichnet, dass die Schichtabscheidung meist weitab vom thermischen Gleichgewicht erfolgt, d.h. bei niedrigeren Substrattemperaturen. Das verdampfte Material wird also bei der Abscheidung am Substrat schnell abgekühlt. Dieses schnelle Abkühlen hat zur Folge, dass sich nur kleine Kristallite in der Schichtausbilden können. Teilweise ist das erwünscht, um amorphe Schichtstrukturen herzustellen. In einigen Fällen sind aber grössere Kristallite von Vorteil. Nach dem Stand der Technik wird man dann bei PVD Prozessen entweder die Substrattemperatur erhöhen durch Heizen oder man wird versuchen, zusätzliche Energie über den Ionenbeschuss in die aufwachsende Schicht einzubringen. Auf der Grundlage der vorliegenden Erfindung kann man aber die Zusammensetzung des Legierungstargets so ändern, dass es zu höheren Bildungstemperaturen der Metalloxidschichten kommt, also dass beispielsweise das Al2O3 nicht bei 1100°C, sondern bei 1300°C gebildet wird. Durch die erhöhte Oxidbildungstemperatur ist der Energieeintrag in die Schicht aber auch erhöht, was zu grösseren Kristallen führt. Das Rezept liefert hier wieder die Vorgehensweise.

Natürlich gelten diese Betrachtungen, wie bereits oben erwähnt, nicht nur für binäre Legierungen, sondern auch für ternäre, quarternäre und höhere Legierungen, auf deren Basis man Oxidschichten synthetisieren möchte.

Schliesslich sei noch erwähnt, dass das erfinderische Rezept umgekehrt werden kann und es dadurch in gewissem Sinne sogar möglich ist, Schichten zu synthetisieren, deren Analyse zu einer Erstellung von Phasendiagrammen beitragen kann. D.h. es wurde hiermit ein Verfahren zur Erstellung von Phasendiagrammen offenbart.

Die Erkenntnisse über die Targetzusammensetzung nach den Phasendiagrammen Hochtemperaturoxide herzustellen gelten nicht nur für die reaktive kathodische Funkenverdampfung, sondern auch für reaktives Sputtern und reaktives gepulstes Sputtern (high power and modulated pulsing), allerdings ist dann die Prozessführung nicht so unkompliziert wie im Falle der kathodischen Funkenverdampfung (Sauerstoffregelung).

## Patentansprüche

1. Verfahren zur Herstellung von Schichten, insbesondere hochtemperaturstabile Schichten, mittels Funkenverdampfung umfassend ternäre und/oder höhere Oxide metallischer und halbmetallischer Komponenten, **dadurch gekennzeichnet, dass** eine gezielte Synthese gewünschter Kristallstrukturen der Schicht dadurch erreicht wird, dass die für die Synthese der gewünschten Kristallstruktur notwendige Bildungstemperatur bestimmt wird und anhand des Phasendiagramms die Auswahl der Zusammensetzung des binären (oder höheren) Legierungstargets festgelegt wird derart, dass das Phasendiagramm der Komponenten bei der gewählten Zusammensetzung den Übergang aus der vollständig flüssigen Phase in eine feste Bestandteile umfassende Phase bei einer Temperatur aufweist, die der gewünschten Bildungstemperatur entspricht.

2. Verfahren nach Anspruch 1, **dadurch gekennzeichnet, dass** der Schmelzpunkt der niederschmelzenden Targetmaterialkomponente durch die Beimengung von höherschmelzenden metallischen oder halbmetallischen Komponenten im Legierungstarget gezielt so erhöht wird, dass die Bildungstemperatur des Oxides eingestellt wird.

3. Verfahren nach einem der vorhergehenden Ansprüche, **dadurch gekennzeichnet, dass** die Schichten einen Anteil von mehr als 70 at% Aluminiumoxid in Korundstruktur aufweisen unter Benutzung mindestens eines Legierungstargets bestehend aus Aluminium und mindestens einer weiteren metallischen oder halbmetallischen Komponente, wobei diese Legierung den Übergang aus der vollständig flüssigen Phase in eine feste Bestandteile umfassende Phase zwischen 1000°C und 1200°C aufweist.

4. Verfahren nach einem der vorhergehenden Ansprüche, **dadurch gekennzeichnet**, wobei diese Legierung den Übergang aus der vollständig flüssigen Phase in eine feste Bestandteile umfassende Phase oberhalb 1000°C aufweist.

5. Verfahren nach einem der vorhergehenden Ansprüche, **dadurch gekennzeichnet, dass** die Schicht einen Anteil von mehr als 70 at% Aluminiumoxid in Korundstruktur aufweist unter Benutzung mindestens eines Legierungstargets bestehend aus Aluminium und mindestens einer weiteren metallischen oder halbmetallischen Komponente, vorzugsweise jedoch genau einer weiteren metallischen oder halbmetallischen Komponente, wobei das Target eine der folgenden Zusammensetzungen in at% aufweist:
Eines oder mehrere aus der Gruppe
Au: 20 bis 30
B: kleiner 3
Be: 20 bis 30
C: kleiner 3
Cr: grösser 10 bis 25
Fe: 5 bis 15
Hf: 5 bis 10
Ir: 10 bis 15
La: 10 bis 15
Mo: 2 bis 5
Nb: 1 bis 3
Ta: 1 bis 3
Ti: 2 bis 6
V: 3 bis 8
W: 5 bis 8
Y: 12 bis 16
Zr: 2 bis 4
Rest im Wesentlichen Al, jedoch nicht weniger als 70.

6. Verfahren nach einem der vorhergehenden Ansprüche, **dadurch gekennzeichnet, dass** die Schicht einen Anteil von mehr als 70 at% Aluminiumoxid in Korundstruktur aufweist unter Benutzung mindestens eines Aluminiumtargets (pulvermetallurgisch oder schmelzmetallurgisch hergestellt) mit Beimischungen kleinerer Mengen (kleiner als 20 at% Anteil) einer oder mehrerer metallischer oder halbmetallischer Komponenten, **dadurch gekennzeichnet, dass** die Beimischungen höhere Schmelztemperaturen aufweisen und damit eine Schmelztemperatur des Gemisches von mindestens 1000°C nach Phasendiagramm realisiert wird.

## Claims

1. Method for producing layers, in particular high-temperature-stable layers, by means of spark evaporation, comprising ternary and/or higher oxides of metallic and semimetallic components, **characterised in that** a selective synthesis of desired crystal structures of the layer is obtained by providing that the formation temperature required for the synthesis of the desired crystal structure is determined and the selection of the composition of the binary (or higher) alloy target is, using the phase diagram, defined in such a way that the phase diagram of the components exhibits, at the selected composition, the transition from the completely liquid phase to a phase including solid components at a temperature which corresponds to the desired formation temperature.

2. Method according to claim 1, **characterised in that** the melting point of the target material component having a low melting point is selectively raised by adding metallic or semimetallic components having a higher melting point to the alloy target in such a way that the formation temperature of the oxide is adjusted.

3. Method according to any of the preceding claims, **characterised in that** the layers comprise a proportion of more than 70 atomic % of aluminium oxide in corundum structure, using at least one alloy target consisting of aluminium and at least one further metallic or semimetallic component, the transition from the completely liquid phase of this alloy to a phase including solid components happening at a temperature between 1000°C and 1200°C.

4. Method according to any of the preceding claims, **characterised in that** the transition from the completely liquid phase of this alloy to a phase including solid components happens at a temperature above 1000°C.

5. Method according to any of the preceding claims, **characterised in that** the layer comprises a proportion of more than 70 atomic % of aluminium oxide in corundum structure, using at least one alloy target consisting of aluminium and at least one further metallic or semimetallic component, preferably, however, precisely one further metallic or semimetallic component, the target having one of the following compositions in atomic %:
One or more from the group
Au: 20 to 30
B: less than 3
Be: 20 to 30
C: less than 3
Cr: more than 10 to 25
Fe: 5 to 15
Hf: 5 to 10
Ir: 10 to 15
La: 10 to 15
Mo: 2 to 5
Nb: 1 to 3
Ta: 1 to 3
Ti: 2 to 6
V: 3 to 8
W: 5 to 8
Y: 12 to 16
Zr: 2 to 4
Rest essentially Al, but no less than 70.

6. Method according to any of the preceding claims, **characterised in that** the layer comprises a proportion of more than 70 atomic % of aluminium oxide in corundum structure, using at least one aluminium target (produced in a powder-metallurgical or melt-metallurgical process) with the addition of smaller quantities (less than 20 atomic %) of one or more metallic or semimetallic components, **characterised in that** the additions have higher melting temperatures, resulting in a melting temperature of the mixture of at least 1000°C in accordance with the phase diagram.

## Revendications

1. Procédé pour la production de couches, en particulier de couches stables à haute température, au moyen d'une vaporisation à l'arc, comprenant des oxydes ternaires et/ou plus élevés de composants métalliques et semi-métalliques, **caractérisé en ce que** l'on obtient une synthèse ciblée de structures cristallines souhaitées dans la couche **en ce que** l'on détermine la température de formation nécessaire pour la synthèse de la structure cristalline souhaitée et on fixe au moyen du diagramme de phase le choix de la composition de la cible d'alliage binaire (ou plus élevée), de telle manière que le diagramme de phase des composantes correspond, pour la composition choisie, à la transition de la phase totalement liquide en une phase incluant des composantes solides à une température qui correspond à la température de formation souhaitée.

2. Procédé selon la revendication 1, **caractérisé en ce que** le point de fusion des composantes à bas point de fusion du matériau de la cible est augmenté, par addition de composantes métalliques ou semi-métalliques à haut point de fusion dans la cible d'alliage, de manière ciblée de telle façon que l'on règle la température de formation de l'oxyde.

3. Procédé selon l'une des revendications précédentes, **caractérisé en ce que** les couches présentent une proportion de plus de 70 atomes % d'oxyde d'aluminium en structure de corindon, en utilisant au moins une cible d'alliage constituée d'aluminium et d'au moins une autre composante métallique ou semi-métallique, et cet alliage présente la transition de la phase totalement liquide vers une phase incluant des composantes solides entre 1000° C et 1200° C.

4. Procédé selon l'une des revendications précédentes, **caractérisé en ce que** cet alliage présente la transition de la phase totalement liquide vers une phase incluant des composantes solides au-dessus de 1000° C.

5. Procédé selon l'une des revendications précédentes, **caractérisé en ce que** la couche comprend une proportion de plus de 70 atomes % d'oxyde d'aluminium en structure de corindon, en utilisant au moins une cible d'alliage constitué d'aluminium et d'au moins une autre composante métallique ou semi-métallique, de préférence toutefois exactement une autre composante métallique ou semi-métallique, et la cible présente l'une des compositions suivantes, en atomes % :
un ou plusieurs éléments du groupe
Au : 20 à 30
B : moins de trois
Be : 20 à 30
C : moins de 3
Cr : plus de 10 à 25
Fe : 5 à 15
Hf : 5 à 10
Ir : 10 à 15
La : 10 à 15
Mo : 2 à 5
Nb : 1 à 3
Ta : 1 à 3
Ti : 2 à 6
V : 3à8
W : 5 à 8
Y : 12 à 16
Zr : 2à4
le reste étant sensiblement du Al, mais sans être inférieur à 70.

6. Procédé selon l'une des revendications précédentes, **caractérisé en ce que** la couche comprend une proportion de plus de 70 atomes % d'oxyde d'aluminium en structure de corindon, en utilisant au moins une cible d'aluminium (produite par des techniques de métallurgie des poudres ou des techniques de métallurgie par fusion) avec addition de petites quantités (inférieures à 20 atomes %) d'une ou de plusieurs composantes métalliques ou semi-métalliques, **caractérisé en ce que** les additions présentent des températures de fusion plus élevées et l'on réalise ainsi une température de fusion du mélange d'au moins 1000° C selon le diagramme de phase.
